# EUROPEAN PATENT APPLICATION

(11) **EP 3 195 926 A1**
(43) Date of publication of application: **26.07.2017**
(21) Application number: 15842759.1
(22) Date of filing: 09.09.2015
(51) Int. Cl.: B01F 15/02, B01F 1/00, B01F 3/04, B01F 5/04, B01F 15/04, C01B 13/10, C01B 13/11, C02F 1/78, H01L 21/304

(54) **DEVICE AND METHOD FOR MANUFACTURING GAS-DISSOLVED WATER**

(30) Priority: 18.09.2014 JP 2014189639; 28.11.2014 JP 2014240990
(71) Applicant: Ebara Corporation, Ohta-ku, Tokyo 144-8510 (JP)
(72) Inventor: OZAWA, Suguru, Tokyo 144-8510 (JP); HARADA, Minoru, Tokyo 144-8510 (JP); TAKAHASHI, Muneto, Tokyo 144-8510 (JP)
(74) Representative: Schmidbauer, Andreas Konrad
(86) International application number: PCT/JP2015/004586
(87) International publication number: WO 2016/042740

(57) **Abstract**

An ozone water production device (1) includes: flow rate controllers (4, 5) that each control a flow rate of gas which is a raw material; a flow rate meter (12) that measures a flow rate of water which is a raw material; a booster pump (13) that controls pressure of the water; an ozone water generating unit (8) that generates ozone water by mixing ozone gas and the water; and a pressure sensor (17) that measures pressure of the ozone water which is to be supplied to a use point (19). The booster pump (13) controls the pressure of the water such that the pressure of the ozone water measured by the pressure sensor (17) is constant. The flow rate controllers (4, 5) each control the flow rate of the gas in accordance with the flow rate of the water measured by the flow rate meter (12).

## Description

### Technical Field

The present invention relates to a gas-dissolved water production device that produces gas-dissolved water by mixing gas and water which are raw materials.

### Background Art

Recently, in a semiconductor device plant or a manufacturing plant for electronic components such as liquid crystal components, advancement of cleaning products has been facilitated due to increasingly complicated production processes and microfabricated circuit patterns. For example, a special liquid (called "cleaning liquid") produced by dissolving a high-purity gas, or a high-purity gas and chemicals dissolved in functional water (e.g., ultrapure water) is used to remove fine particles, metals, organic matter, and the like attached on silicon wafers.

As a cleaning processing method therefor, a "batch processing method" of repeatedly performing immersing and cleaning operations on a plurality of silicon wafers at the same time or a "sheet processing method" of performing chemical cleaning and ultrapure-water cleaning on each wafer so as to handle products which are manufactured in many kinds in small quantities, is adopted. In the sheet processing method, since a cleaning process time (a tact time) for one wafer is longer than, and the usage quantity of a cleaning liquid is larger than those in the batch processing method, reduction of the tact time and reduction of the usage quantity of a cleaning liquid have been demanded. In order to perform cleaning effectively in a short time and to reduce the usage quantity of a cleaning liquid, an advanced cleaning process is currently being performed in which cleaning processes are switched in a short time while a plurality of types of functional water and chemicals are used singly or together.

As such functional water, ozone water produced by dissolving ozone gas in ultrapure water is used. Ozone water is generally produced by an ozone water production device. Due to advancement and complexity of cleaning processes, a short-time supply and supply-stop of ozone water to a cleaning device has been demanded. However, in conventional devices, once production of ozone water is stopped, a certain time (a rise time) is needed to enable again supply of ozone water at a required ozone concentration, at a required flow rate. Thus, in order to meet demands for supply of ozone water to cleaning devices, ozone water production devices constantly produce ozone water and continuously supply ozone water to the cleaning devices. As a result, cleaning devices are excessively supplied with ozone water, and thus, unused ozone water, which is not used to clean silicon wafers, is discharged as exhaust water from the cleaning devices.

Accordingly, a circulation-type ozone water supply device has been conventionally proposed which is capable of supplying ozone water at a constant concentration, at a constant pressure and of reusing unused ozone water, regardless of the usage quantity of ozone water at a use point (see Patent Literature 1).

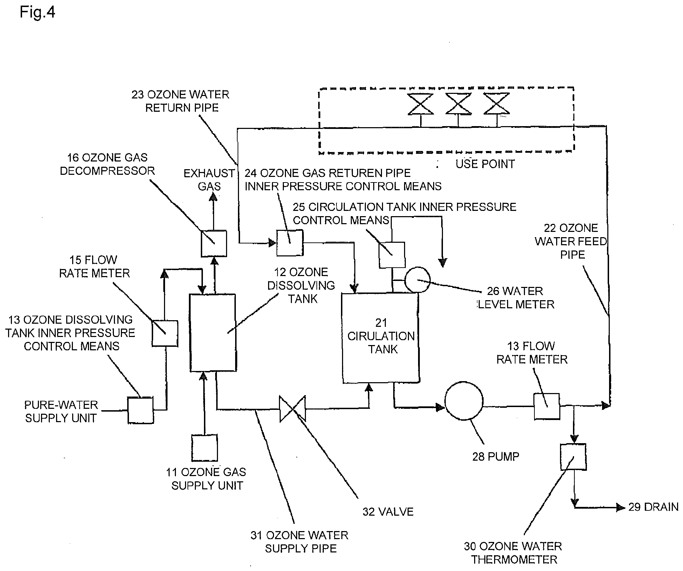

As illustrated in Figure 4, in the conventional circulation-type ozone water supply device, water and ozone gas are supplied into an ozone dissolving tank 12 to generate ozone water, the ozone water is supplied from the ozone dissolving tank 12 to a circulation tank 21, the ozone water is supplied from the circulation tank 21 to a use point via an ozone water feed pipe 22, the ozone water unconsumed at the use point is returned to the circulation tank 21 via an ozone water return pipe 23, and then, ozone water is again supplied from the circulation tank 21 to the use point. The inner pressure of the ozone dissolving tank 12, the inner pressure of the circulation tank 21, and the inner pressure of the ozone water return pipe 23 are each maintained to be constant, while control is performed such that the inner pressure of the circulation tank is lower than that of the ozone dissolving tank or that of the ozone water return pipe.

However, since the conventional ozone water supply device is a circulation type in which ozone water (unused ozone water) to be reused is circulated, the device requires a countermeasure against increase in temperature of the ozone water (unused ozone water) or occurrence of contamination during circulation of the ozone water. Therefore, development of a technique for producing only a necessary quantity of ozone water for a use point has been demanded.

### Citation List

### Patent Literature

Patent Literature 1: Japanese Patent Laid-Open No. 2014-117628

### Summary of Invention

### Technical Problem

The present invention has been made in view of the above problems. An object of the present invention is to provide a gas-dissolved water production device capable of producing only a necessary quantity of ozone water for a use point, without requiring a countermeasure against increase in temperature of the ozone water or occurrence of contamination during circulation.

### Solution to Problem

An aspect of the present invention is a gas-dissolved water production device including a gas flow rate control unit that controls a flow rate of gas which is a raw material, a water flow rate measuring unit that measures a flow rate of water which is a raw material, a water pressure control unit that controls pressure of the water, a gas-dissolved water generating unit that generates gas-dissolved water by mixing the gas and the water, and a pressure measuring unit that measures pressure of the gas-dissolved water which is to be supplied to a use point, wherein the water pressure control unit controls the pressure of the water such that the pressure of the gas-dissolved water measured by the pressure measuring unit is constant, and the gas flow rate control unit controls the flow rate of the gas in accordance with the flow rate of the water measured by the water flow rate measuring unit.

Another aspect of the present invention is a gas-dissolved water production method including a gas flow rate control step of controlling a flow rate of gas which is a raw material, a water flow rate measuring step of measuring a flow rate of water which is a raw material, a water pressure control step of controlling pressure of the water, a gas-dissolved water generating step of generating gas-dissolved water by mixing the gas and the water, and a pressure measuring step of measuring pressure of the gas-dissolved water which is to be supplied to a use point, wherein in the water pressure control step, the pressure of the water is controlled such that the pressure of the gas-dissolved water measured at the pressure measuring step is constant, and in the gas flow rate control step, the flow rate of the gas is controlled in accordance with the flow rate of the water measured at the water flow rate measuring step.

As described below, the present invention includes other aspects. Therefore, the disclosure of the invention is intended to provide some of the aspects, and not intended to limit the scope of the invention which is described and claimed here.

### Brief Description of Drawings

[Figure 1] Figure 1 is a diagram illustrating the configuration of an ozone water production device according to a first embodiment of the present invention.
[Figure 2] Figure 2 is a plan view of an electric discharge body according to the first embodiment of the present invention.
[Figure 3] Figure 3 is a cross-sectional view of the electric discharge body according to the first embodiment of the present invention.
[Figure 4] Figure 4 is a diagram illustrating the configuration of a conventional ozone water production device.
[Figure 5] Figure 5 is a diagram illustrating the configuration of an ozone water production device according to a second embodiment of the present invention.
[Figure 6] Figure 6 is a diagram showing feedback control of a gas quantity according to the second embodiment of the present invention.

### Description of Embodiments

Detailed description of the present invention will be given below. However, the detailed description and the attached drawings are not intended to limit the invention.

A gas-dissolved water production device according to the present invention includes a gas flow rate control unit that controls a flow rate of gas which is a raw material, a water flow rate measuring unit that measures a flow rate of water which is a raw material, a water pressure control unit that controls pressure of the water, a gas-dissolved water generating unit that generates gas-dissolved water by mixing the gas and the water, and a pressure measuring unit that measures pressure of the gas-dissolved water which is to be supplied to a use point. The water pressure control unit controls the pressure of the water such that the pressure of the gas-dissolved water measured by the pressure measuring unit is constant. The gas flow rate control unit controls the flow rate of the gas in accordance with the flow rate of the water measured by the water flow rate measuring unit.

With this configuration, the pressure of the water is controlled such that the pressure of the gas-dissolved water which is to be supplied to the use point is constant, and the flow rate of the gas is controlled in accordance with the flow rate of the water which is to be supplied to the gas-dissolved water generating unit, and thereby, only a necessary quantity of gas-dissolved water for the use point is produced. For example, in a case where a large quantity of gas-dissolved water is necessary for the use point, with the constant pressure of the gas-dissolved water which is to be supplied to the use point, a large quantity of water is supplied to the gas-dissolved water generating unit, and a large quantity of gas is supplied to the gas-dissolved water generating unit in accordance with the quantity of water. As a result, a large quantity of gas-dissolved water is produced. In a case where only a small quantity of gas-dissolved water is necessary for the use point, with the constant pressure of gas-dissolved water which is to be supplied to the use point, a small quantity of water is supplied to the gas-dissolved water generating unit, and a small quantity of gas is supplied to the gas-dissolved water generating unit in accordance with the quantity of water. As a result, a small quantity of gas-dissolved water is produced. In this way, only a necessary quantity of gas-dissolved water for the use point can be produced. Further, unlike conventional configurations, this device requires no countermeasure against increase in temperature of the gas-dissolved water or occurrence of contamination during circulation.

The gas-dissolved water production device according to the present invention may further include a concentration measuring unit that measures concentration of the gas-dissolved water, and a control unit that controls, on the basis of the concentration of the gas-dissolved water measured by the concentration measuring unit, the flow rate of the gas so as to reduce a difference between a measured value of the concentration of the gas-dissolved water and a target value.

With this configuration, the flow rate of the gas is controlled on the basis of the concentration of the gas dissolved-water, and thereby, a difference between the measured value of the concentration of the gas-dissolved water and the target value can be reduced (eliminated). Accordingly, even in a case where a difference is likely to occur between the measured value of the concentration of the gas-dissolved water and the target value, for example, in a case where an operation is resumed after suspension for a certain period (for example, a few days), the gas-dissolved water the concentration of which is close to the target value can be produced.

Moreover, in the gas-dissolved water production device according to the present invention, the water pressure control unit may control the pressure of the water within a pressure range of 0.1 to 1 MPa.

With this configuration, the water which is in a state where the pressure thereof is increased to a high pressure (0.1 to 1 MPa) is mixed with the gas, and thereby, highly concentrated gas-dissolved water can be produced.

Furthermore, in the gas-dissolved water production device according to the present invention, the gas-dissolved water generating unit may include a mixer that mixes the gas and the water by using a Venturi effect.

With this configuration, the gas and the water can be efficiently mixed by using the Venturi effect.

Moreover, the gas-dissolved water production device according to the present invention may include a degassing treatment unit that performs degassing treatment on the water which is to be supplied to the gas-dissolved water generating unit.

With this configuration, surplus gas in the water can be removed through degassing treatment, and thereby, dissolution of the gas in the water can be facilitated.

Furthermore, in the gas-dissolved water production device according to the present invention, the gas which is a raw material may be ozone gas and the gas-dissolved water may be ozone water.

With this configuration, only a necessary quantity of ozone water for the use point can be produced. Further, unlike conventional configurations, no countermeasure against increase in temperature of the ozone water or occurrence of contamination during circulation is required.

Moreover, the gas-dissolved water production device according to the present invention may further include an ozone gas generating unit that generates the ozone gas, the ozone gas generating unit may include an electrode for electric discharge to be used for generating the ozone gas, and a holding member which holds the electrode may use stainless steel as the material thereof and have a thickness of 10 mm or greater.

With this configuration, the strength of the holding member for the electrode for electric discharge to be used for generating the ozone gas can be made sufficiently high, and thereby, high pressure (0.1 to 1 MPa) ozone gas can be produced.

A gas-dissolved water production method according to the present invention includes a gas flow rate control step of controlling a flow rate of gas which is a raw material, a water flow rate measuring step of measuring a flow rate of water which is a raw material, a water pressure control step of controlling pressure of the water, a gas-dissolved water generating step of generating gas-dissolved water by mixing the gas and the water, and a pressure measuring step of measuring pressure of the gas-dissolved water which is to be supplied to a use point. In the water pressure control step, the pressure of the water is controlled such that the pressure of the gas-dissolved water measured at the pressure measuring step is constant. In the gas flow rate control step, the flow rate of the gas is controlled in accordance with the flow rate of the water measured at the water flow rate measuring step.

Also with this production method, as in the above production device, the pressure of the water is controlled such that the pressure of the gas-dissolved water which is to be supplied to the use point is constant, and the flow rate of the gas is controlled in accordance with the flow rate of the water which is to be supplied to the gas-dissolved water generating unit, and thereby, only a necessary quantity of gas-dissolved water for the use point is produced. For example, in a case where a large quantity of gas-dissolved water is necessary for the use point, with the constant pressure of gas-dissolved water which is to be supplied to the use point, a large quantity of water is supplied to the gas-dissolved water generating unit, and a large quantity of gas is supplied to the gas-dissolved water generating unit in accordance with the quantity of water. As a result, a large quantity of gas-dissolved water is produced. In a case where only a small quantity of gas-dissolved water is necessary for the use point, with the constant pressure of gas-dissolved water which is to be supplied to the use point, a small quantity of water is supplied to the gas-dissolved water generating unit, and a small quantity of gas is supplied to the gas-dissolved water generating unit in accordance with the quantity of water. As a result, a small quantity of gas-dissolved water is produced. In this way, only a necessary quantity of gas-dissolved water for the use point can be produced. Further, unlike conventional methods, this method requires no countermeasure against increase in temperature of the gas-dissolved water or occurrence of contamination during circulation.

According to the present invention, only a necessary quantity of gas-dissolved water for a use point can be produced, without requiring a countermeasure against increase in temperature of the gas-dissolved water or occurrence of contamination during circulation.

Hereinafter, description of a gas-dissolved water production device according to embodiments of the present invention will be given with reference to the drawings. In the embodiments, an ozone water production device to be used for cleaning electronic components such as semiconductor devices and liquid crystal components is described as an example.

### (First Embodiment)

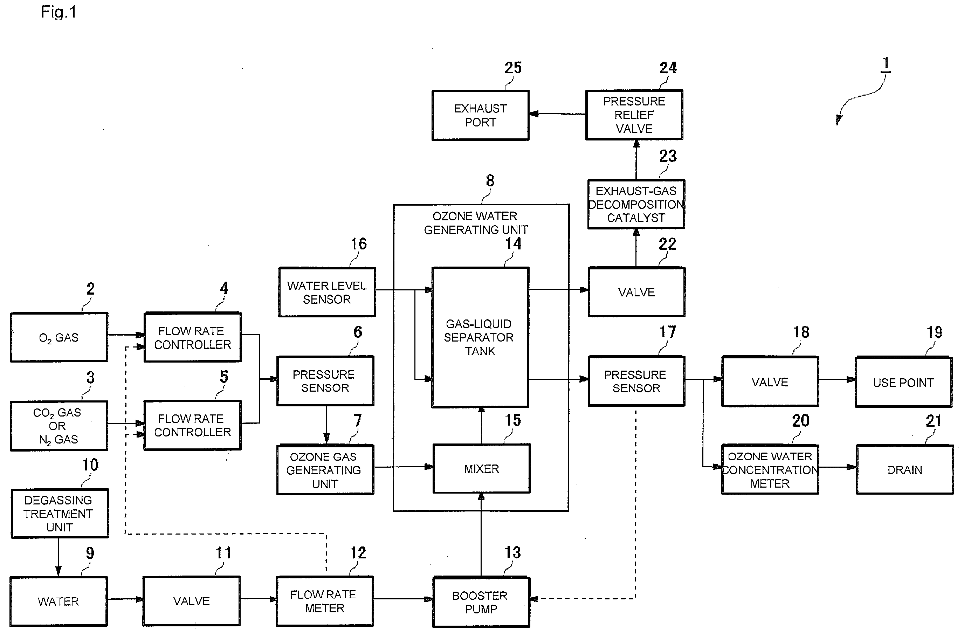

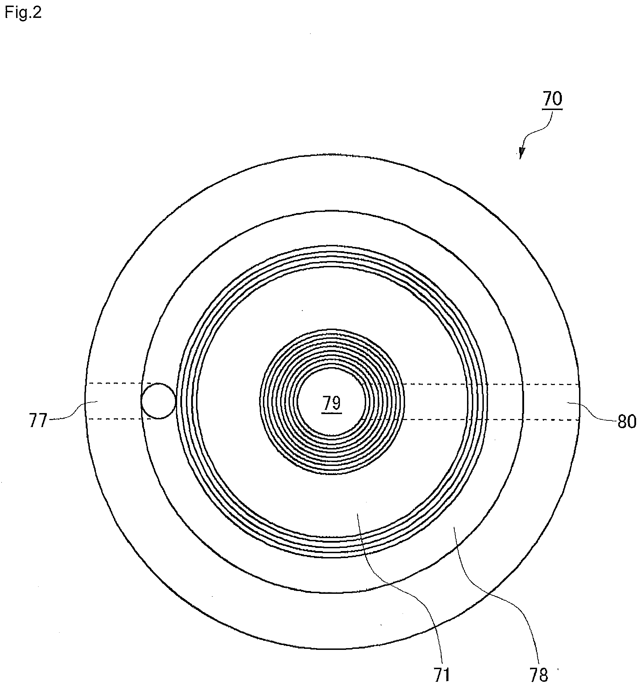

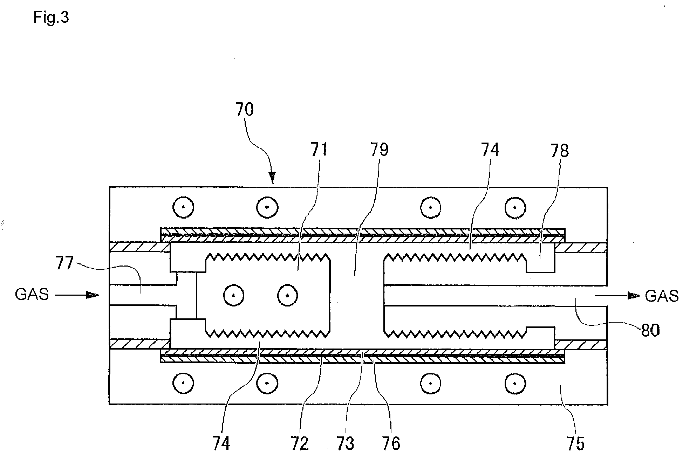

The configuration of a gas-dissolved water production device according to a first embodiment of the present invention will be described with reference to the drawings. Figure 1 is a diagram illustrating the configuration of an ozone water production device according to the first embodiment. As illustrated in Figure 1, the ozone water production device 1 includes respective supply sources 2, 3 of a first gas (O₂ gas) and a second gas (CO₂ gas or N₂ gas), which are raw materials, and flow rate controllers 4, 5 that controls the flow rates of corresponding gases (the first gas and the second gas). The second gas (CO₂ gas or N₂ gas) is not necessarily required, and only the first gas (O₂ gas) may be used. After the pressures of the first gas and the second gas are measured by a pressure sensor 6, the first gas and the second gas are sent to an ozone gas generating unit 7. The ozone gas generating unit 7 includes an electric discharge body 70 that generates ozone gas, through electric discharge, from the first gas (O₂ gas) and the second gas (CO₂ gas or N₂ gas) (see Figures 2 and 3). The ozone gas generated by the ozone gas generating unit 7 is sent to an ozone water generating unit 8.

Further, the ozone water production device 1 includes a supply source 9 of water (ultrapure water) which is a raw material. In order to remove surplus gas (oxygen, nitrogen, or carbonic acid gas) in water which is a raw material, the ozone water production device 1 includes a degassing treatment unit 10 that performs degassing treatment. For degassing treatment, a known method of performing evacuation through a degassing treatment film may be used, for example. Moreover, the ozone water production device 1 is provided with a valve 11 for adjusting the flow rate of water and a flow rate meter 12 for measuring the flow rate of water. After the flow rate of the water which is a raw material is measured by the flow rate meter 12, the water is sent to a booster pump 13, the pressure thereof is adjusted by the booster pump 13, and then, the water is sent to the ozone water generating unit 8. The pressure of the water to be sent to the ozone water generating unit 8 is set to 0.1 to 1.0 MPa, for example.

The ozone water generating unit 8 includes a mixer 14 that mixes ozone gas and water to generate ozone water. It is preferable that the mixer 14 mixes gas and water by using the Venturi effect. For example, an aspirator, an ejector, or the like is used as the mixer 14. The generated ozone water is sent to a gas-liquid separator tank 15. In the gas-liquid separator tank 15, gas (exhaust gas) is separated from the ozone water. The gas-liquid separator tank 15 may be provided with a water level sensor 16 in order to measure the water level of the ozone water. The pressure of the ozone water having undergone gas-liquid separation is measured by a pressure sensor 17, and then, the ozone water is sent to a use point 19 (for example, a multi-chamber sheet type cleaning device or the like) through a valve 18. After the concentration of the ozone water having undergone gas-liquid separation is measured by an ozone water concentration meter 20, the ozone water is discharged to a drain 21. On the other hand, the exhaust gas is sent to an exhaust-gas decomposition catalyst 23 through a valve 22 and is subjected to decomposition treatment, the pressure of the exhaust gas is restored to the atmospheric pressure by a pressure relief valve 24, and then, the exhaust gas is discharged through an exhaust port 25.

As the pressure relief valve 24, an air control type relief valve is desirably adopted because such a valve can maintain a constant pressure while preventing sudden pressure change. In a case where there is no possibility of occurrence of sudden pressure change, a spring type relief valve may be adopted. A spring type relief valve is more inexpensive than an air control type relief valve, and has an advantage to achieve low cost.

Here, the configuration of the electric discharge body 70 of the ozone gas generating unit 7 will be described with reference to the drawings. Figure 2 is a plan view of the electric discharge body 70, and Figure 3 is a cross-sectional view of the electric discharge body 70. As illustrated in Figures 2 and 3, the electric discharge body 70 of the ozone gas generating unit 7 includes a pair of a low voltage electrode 71 and a high voltage electrode 72 having circular electrode surfaces opposed to each other, a dielectric body 73 disposed between the opposed electrode surfaces of both electrodes, and a disk-shaped space 74. In the disk-shaped space 74 between the opposed electrode surfaces, mild electric discharge occurs. When raw material gases (the first gas and the second gas) including oxygen flow through the space, the oxygen is converted to ozone through electric discharge.

The high voltage electrode 72 is connected to the higher voltage side of a high voltage AC power source, and the low voltage electrode 71 is connected to the lower voltage side (ground) of the AC power source. As illustrated in Figures 2 and 3, electrode surfaces of the low voltage electrode 71 each have a large number of trench grooves (concentrically arranged grooves) extending in parallel to one another. The structure of the trench grooves may be the same as known one.

The high voltage electrode 72 is formed of a metallic layer between the dielectric body 73 and an insulating body 76 supported by a holding member 75. The holding member 75 uses stainless steel (SUS) as the material thereof and has a thickness of 10 mm or greater (preferably, 16 mm or greater). The dielectric body 73 is formed of a disk-shaped single crystal sapphire, and the high voltage electrode 72 is formed of a silver-based metallization layer provided on the rear surface of the sapphire. In this case, a space between the ridges of the trench grooves and a surface of the dielectric plate surface serve as an electric discharge space. The distance between the ridges of the trench grooves and the surface of the dielectric plate surface is 0.01 to 0.3 mm (preferably, 0.03 to 0.05 mm), for example. When ozone gas clean enough to be used for manufacturing semiconductors is required, a sapphire which is a clean material is suited as the material of the dielectric body 73. However, when a high purity is not required, the dielectric body 73 may be formed of a ceramic material such as alumina ceramics.

The raw material gases are introduced into the disk-shaped space 74 through an inlet path 77 and an outer circumferential space 78, are caused to flow through in the disk-shaped space 74 in a substantially radially inward direction, are collected in a central space 79 provided on the central part of the low voltage electrode 71, and are guided to the outside, in a radial direction, of the electrodes through a guidepath 80. Alternatively, the raw material gases may be caused to flow in the disk-shaped space 74 in a radially outward direction, instead of in the substantially radially inward direction. In this case, the raw material gases are supplied first to the central space 79 through the guide path 80, are caused to flow in the disk-shaped space 74 in the substantially radially outward direction, and are guided to the inlet path 77 through the outer circumferential space 78.

The high voltage electrode 72 is connected to the higher voltage side of a high-frequency AC power source, and the low voltage electrode 71 is connected to the lower voltage side of the power source. High AC voltage is applied to the disk-shaped space 74 between both the electrodes, and mild electric discharge occurs in the disk-shaped space 74 between both the electrodes. The raw material gases (the first gas and the second gas) including oxygen are caused to flow through the disk-shaped space 74 so that a part of the gases is converted to ozone. In the electric discharge body 70 in Figures 2 and 3, highly concentrated ozone can be generated because the raw material gases are caused to flow in a direction crossing the large number of trench grooves so as to inevitably pass over the top sections of the grooves at which the discharge density is high.

Operations of the ozone water production device 1 having the above configuration will be described.

To produce ozone water by using the ozone water production device 1 according to the embodiment of the present invention, first, the first gas (O₂ gas) and the second gas (CO₂ gas or N₂ gas) which are raw materials are supplied from the supply sources 2, 3, respectively. The flow rates of the gasses (the first gas and the second gas) are controlled by the flow rate controllers 4, 5, respectively. On the other hand, water (ultrapure water) which is a raw material is supplied from the supply source 9. The flow rate of the water is measured by the flow rate meter 12. In the present embodiment, as indicated by a dashed-line arrow in Figure 1, the flow rate controllers 4, 5 control the flow rates of the gasses in accordance with the flow rate of the water measured by the flow rate meter 12.

After the pressures of the first gas and the second gas are measured by the pressure sensor 6, the first gas and the second gas are sent to the ozone gas generating unit 7. At the ozone gas generating unit 7, ozone gas is generated, through electric discharge, from the first gas (O₂ gas) and the second gas (CO₂ gas or N₂ gas). The generated ozone gas is sent to the ozone water generating unit 8. On the other hand, after the flow rate of the water which is a raw material is measured by the flow rate meter 12, the water is sent to the booster pump 13, the pressure of the water is adjusted by the booster pump 13, and then, the water is sent to the ozone water generating unit 8. The booster pump 13 has a function of controlling, within the pressure range of 0.1 to 1 MPa, the pressure of water to be sent to the ozone water generating unit 8. For example, a centrifugal pump is used as the booster pump 13. In the present embodiment, the booster pump 13 controls the pressure of the water such that the pressure of ozone water measured by the pressure sensor 17 is constant. Here, the difference between the pressure of the water and the pressure of the ozone gas is desirably within 150 KPa.

In the mixer 14 of the ozone water generating unit 8, the ozone gas and the water are mixed to generate ozone water, and the generated ozone water is sent to the gas-liquid separator tank 15. In the gas-liquid separator tank 15, a gas (exhaust gas) is separated from the ozone water. The pressure of the ozone water having undergone gas-liquid separation is measured by the pressure sensor 17, and the ozone water is sent to the use point 19 (for example, a multi=chamber sheet type cleaning device or the like) through the valve 18.

According to the ozone water production device 1 according to the present embodiment described above, the pressure of the water is controlled such that the pressure of the ozone water which is to be supplied to the use point 19 is constant, and the flow rate of the gas is controlled in accordance with the flow rate of the water which is to be supplied to the ozone water generating unit 8, and thereby, only a necessary quantity of ozone water for the use point 19 is produced.

For example, in a case where a large quantity of ozone water is necessary for the use point 19, with the constant pressure of ozone water to be supplied to the use point 19, a large quantity of water is supplied to the ozone water generating unit 8, and a large quantity of gas is supplied to the ozone water generating unit 8 in accordance with the quantity of water. As a result, a large quantity of ozone water is produced.

1 In contrast, in a case where only a small quantity of ozone water is necessary for the use point 19, with the constant pressure of ozone water to be supplied to the use point 19, a small quantity of water is supplied to the ozone water generating unit 8, and a small quantity of gas is supplied to the ozone water generating unit 8 in accordance with the quantity of water. As a result, a small quantity of ozone water is produced. Accordingly, the usage quantity of gas can be reduced, compared with those by conventional devices. In addition, a quantity of discharged water can also be reduced, compared with those from conventional devices.

As described above, the ozone water production device 1 according to the present embodiment can supply a necessary quantity of ozone water for the use point 19 at a constant concentration (a constant pressure), even when the necessary quantity of ozone water for the use point 19 changes. Therefore, the ozone water production device 1 is suited for a multi-chamber sheet type cleaning device. In addition, the ozone water production device 1 according to the present embodiment, unlike conventional devices, requires no countermeasure against increase in temperature of ozone water or occurrence of contamination during circulation, because it is not necessary to cause ozone water to circulate.

In the ozone water production device 1 according to the present embodiment, the water which is in a state where the pressure thereof is increased to a high pressure (0.1 to 1 MPa) is mixed with the gas, and thereby, highly concentrated ozone water can be produced.

Furthermore, in the ozone water production device 1 according to the present embodiment, the gas and the water can be efficiently mixed by using the Venturi effect.

Moreover, in the ozone water production device 1 according to the present embodiment, surplus gas in the water can be removed through degassing treatment, and thereby, dissolution of the ozone gas in the water can be facilitated.

Furthermore, in the ozone water production device 1 according to the present embodiment, the strength of the holding member 75 for the electrodes for electric discharge used for generating ozone gas is sufficiently high, and thereby, high pressure (0.1 to 1 MPa) ozone gas can be produced.

### (Second Embodiment)

Next, an ozone water production device according to a second embodiment of the present invention will be described. Here, features of the ozone water production device of the second embodiment different from those of the first embodiment will be mainly described. Unless otherwise specifically mentioned, the configuration and operations in the present embodiment are identical to those in the first embodiment.

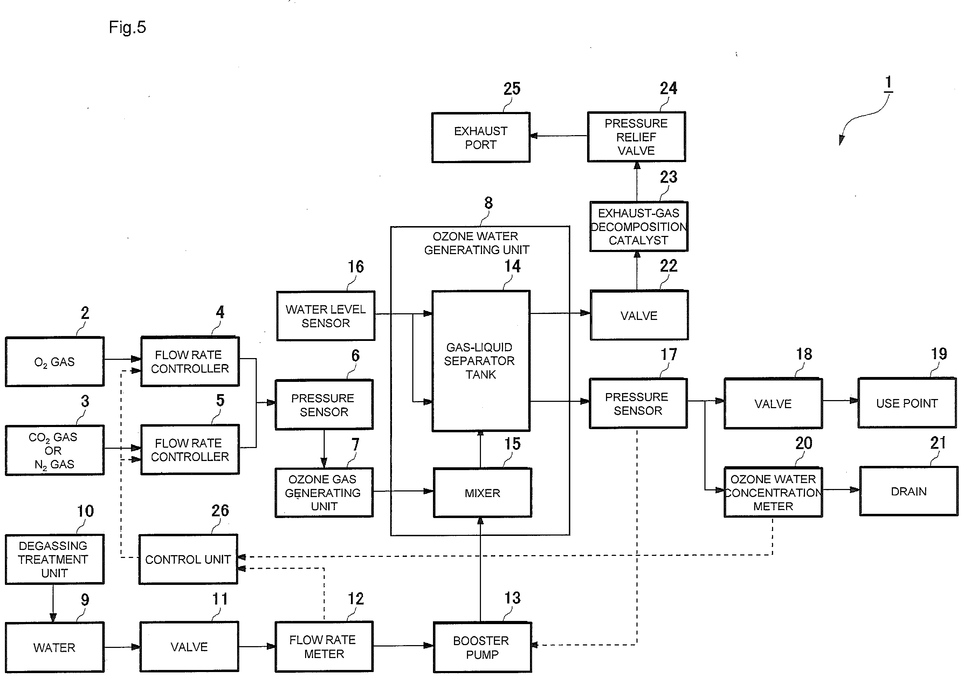

Figure 5 is a diagram illustrating the configuration of the ozone water production device according to the second embodiment. As illustrated in Figure 5, the ozone water production device 1 of the present embodiment includes a control unit 26 configured to control the flow rates of the first gas (O₂ gas) and the second gas (CO₂ gas and N₂ gas), which are raw materials of ozone water.

The control unit 26 controls the flow rates of the first gas (O₂ gas) and the second gas (CO₂ gas or N₂ gas), which are raw materials of ozone water, on the basis of a difference between the ozone water concentration (a measured value) measured by the ozone water concentration meter 20 and an ozone water concentration to be achieved (a target value). In this case, the control unit 26 performs feedback control on the total flow rate of the first gas and the second gas, so as to reduce (eliminate) the difference between the measured value of the ozone water concentration and the target value.

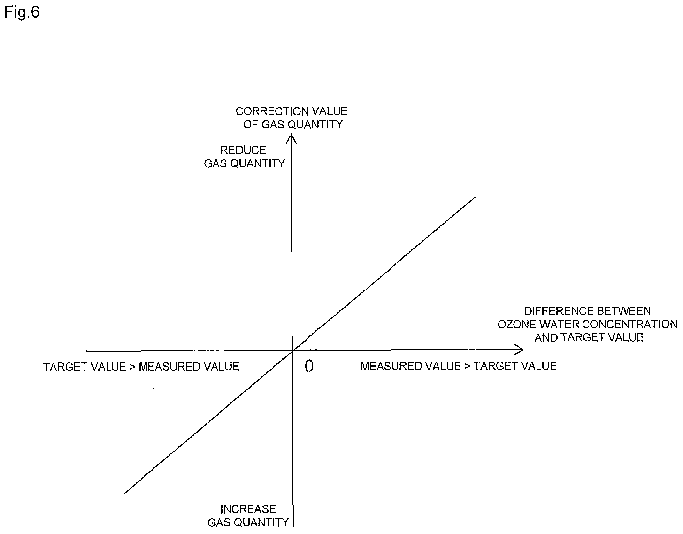

More specifically, as shown in Figure 6, when the measured value of the ozone water concentration is greater than the target value, flow-rate correction is performed so as to reduce the total flow rate of the gasses (the first gas and the second gas). When the measured value of the ozone water concentration is less than the target value, flow-rate correction is performed so as to increase the total flow rate of the gasses (the first gas and the second gas).

Also according to the ozone water production device 1 of the second embodiment, the same effects as those provided by the first embodiment are provided.

In addition to the effects, in the present embodiment, since the control unit 26 performs feedback control on the total flow rate of the first gas and the second gas, the difference between the measured value of the ozone water concentration and the target value can be reduced (eliminated). Therefore, even in a case where a difference is likely to occur between the measured value of the ozone water concentration and the target value, for example, in a case where an operation is resumed after suspension for a certain period (for example, a few days), ozone water the concentration of which is close to the target value can be produced.

As some of the examples, the embodiments of the present invention have been described above. However, the scope of the present invention is not limited to the above embodiments. The present invention can be changed and modified, according to a purpose, within the scope of the claimed invention.

For example, the ozone water production device 1 which produces ozone water by mixing ozone gas and water has been described above. However, gas-dissolved water may be produced by mixing water and gas (for example, H₂, CO₂, O₂, N₂, Ar, or Xe gas) other than ozone gas.

The preferred embodiments of the present invention which are considered at this moment have been described above. However, it is understood that various modifications may be made for the embodiments, and the attached claims are intended to include all these modifications within the real spirit and scope of the present invention.

### Industrial Applicability

As described above, the gas-dissolved water production device according to the present invention exerts an effect of enabling production of only a necessary quantity of gas-dissolved water for a use point, without requiring a countermeasure against increase in temperature of the gas-dissolved water or occurrence of contamination during circulation, and is useful, for example, as an ozone water production device, etc. used for cleaning electronic components such as semiconductor devices and liquid crystal components.

### Reference Signs List

1 Ozone water production device (gas-dissolved water production device)
2 Supply source
3 Supply source
4 Flow rate controller (gas flow rate control unit)
5 Flow rate controller (gas flow rate control unit)
6 Pressure sensor
7 Ozone gas generating unit
8 Ozone water generating unit (gas-dissolved water generating unit)
9 Supply source
10 Degassing treatment unit
11 Valve
12 Flow rate meter (water flow rate measuring unit)
13 Booster pump (water pressure control unit)
14 Mixer
15 Gas-liquid separator tank
16 Water level sensor
17 Pressure sensor (pressure measuring unit)
18 Valve
19 Use point
70 Electric discharge body
72 High voltage electrode (electrode)
75 Holding member

## Claims

1. A gas-dissolved water production device comprising:
a gas flow rate control unit that controls a flow rate of gas which is a raw material;
a water flow rate measuring unit that measures a flow rate of water which is a raw material;
a water pressure control unit that controls pressure of the water;
a gas-dissolved water generating unit that generates gas-dissolved water by mixing the gas and the water; and
a pressure measuring unit that measures pressure of the gas-dissolved water which is to be supplied to a use point, wherein
the water pressure control unit controls the pressure of the water such that the pressure of the gas-dissolved water measured by the pressure measuring unit is constant, and
the gas flow rate control unit controls the flow rate of the gas in accordance with the flow rate of the water measured by the water flow rate measuring unit.

2. The gas-dissolved water production device according to claim 1, comprising:
a concentration measuring unit that measures concentration of the gas-dissolved water; and
a control unit that controls, on the basis of the concentration of the gas-dissolved water measured by the concentration measuring unit, the flow rate of the gas so as to reduce a difference between a measured value of the concentration of the gas-dissolved water and a target value.

3. The gas-dissolved water production device according to claim 1, wherein
the water pressure control unit controls the pressure of the water within a pressure range of 0.1 to 1 MPa.

4. The gas-dissolved water production device according to claim 1, wherein
the gas-dissolved water generating unit includes a mixer that mixes the gas and the water by using a Venturi effect.

5. The gas-dissolved water production device according to claim 1, comprising:
a degassing treatment unit that performs degassing treatment on the water which is to be supplied to the gas-dissolved water generating unit.

6. The gas-dissolved water production device according to claim 1, wherein
the gas which is a raw material is ozone gas and the gas-dissolved water is ozone water.

7. The gas-dissolved water production device according to claim 6, comprising:
an ozone gas generating unit that generates the ozone gas, wherein
the ozone gas generating unit includes an electrode for electric discharge to be used for generating the ozone gas, and
a holding member which holds the electrode uses stainless steel as the material thereof and has a thickness of 10 mm or greater.

8. A gas-dissolved water production method comprising:
a gas flow rate control step of controlling a flow rate of gas which is a raw material;
a water flow rate measuring step of measuring a flow rate of water which is a raw material;
a water pressure control step of controlling pressure of the water;
a gas-dissolved water generating step of generating gas-dissolved water by mixing the gas and the water; and
a pressure measuring step of measuring pressure of the gas-dissolved water which is to be supplied to a use point, wherein
in the water pressure control step, the pressure of the water is controlled such that the pressure of the gas-dissolved water measured at the pressure measuring step is constant, and
in the gas flow rate control step, the flow rate of the gas is controlled in accordance with the flow rate of the water measured at the water flow rate measuring step.
